# EUROPÄISCHE PATENTANMELDUNG

(11) **EP 0 895 449 A2**
(43) Veröffentlichungstag der Anmeldung: **03.02.1999**
(21) Anmeldenummer: 98250254.4
(22) Anmeldetag: 10.07.1998
(51) Int. Cl.: H05K 9/00

(54) **Elektrisch leitfähige Dichtung und Verfahren zu deren Herstellung**

(30) Priorität: 29.07.1997 DE 19733627
(71) Anmelder: Nauhaus Elektronik GmbH, 13359 Berlin (DE)
(72) Erfinder: Neuhaus, Alexander, Dipl.-Ing., 13467 Berlin (DE)
(74) Vertreter: Wablat, Wolfgang, Dr.Dr.

(57) **Zusammenfassung**

Eine elektrisch leitfähige, in frisch extrudiertem Zustand auf eine Dichtfläche aufdosierte Dichtung für die Verbindungsstelle zwischen zwei Gehäuseteilen eines elektronische Bauelemente aufnehmenden leitfähigen Gehäuses zur Abschirmung von Störstrahlen und zur Verhinderung des Stoffaustausches über den Dichtspalt ist durch Koextrusion zwei- oder mehrschichtig ausgebildet und umfaßt mindestens einen innenliegenden, von leitenden Bestandteilen freien elastischen Dichtstoffstrang sowie einen diesen ringförmig umhüllenden außenliegenden Leitmittelstrang mit geringer Eigenelastizität und Wandstärke aus mit elektrisch leitenden Bestandteilen vermischten elastischem Dichtstoff. Im Innern der Dichtung kann zusätzlich oder wahlweise ein Absorberstrang aus in einen Dichtstoff eingebetteten magnetischen Bestandteilen vorgesehen sein.

## Beschreibung

Die Erfindung betrifft eine elektrisch leitfähige Dichtung, bestehend aus einem in frisch extrudiertem, in noch plastischem Zustand auf eine Dichtfläche aufgetragenen, mit elektrisch leitenden Bestandteilen vermischten Dichtstoff, für den Dichtspalt eines elektronische Bauteile aufnehmenden leitfähigen Gehäuses zur elektromagnetischen Abschirmung und zur Verhinderung des Stoffaustausches über den Dichtspalt sowie ein Verfahren zur Herstellung einer derartigen Dichtung.

Es ist bekannt, daß elektronische Bauteile elektromagnetische Störsignale erzeugen, die durch Spalte der Gehäuse, in denen die elektronischen Bauteile untergebracht sind, nach außen gelangen und über Signalleiter auf andere elektronische Bauteile, und zwar wieder durch Spalte der diese aufnehmenden Gehäuse, übertragen werden und zu Beschädigungen und Fehlfunktionen der anderen elektroni-schen Bauteile führen können.

Um zu verhindern, daß die als Störsignal wirkenden elektromagnetischen Wellen aus einem Gehäuse austreten und in ein anderes Gehäuse eindringen und damit die Funktion des betreffenden elektronischen Bauteils beeinträchtigen können, werden die den Spalt des Gehäuses bildenden Oberflächen durch eine elektrisch leitfähige Dichtung gegeneinander abgedichtet. Das ebenfalls leitfähig ausgeführte Gehäuse wirkt in Verbindung mit der leitfähigen Dichtung als Faradayscher Käfig, um so die Abstrahlung elektromagnetischer Wellen zu verhindern bzw. elektronische Bauteile gegen störende Strahlungseinwirkung abzuschirmen.

Neben der Abschirmung elektromagnetischer Störstrahlen aufgrund der Leitfähigkeit des verwendeten Materials besteht eine weitere wesentliche Funktion derartiger Dichtungen im Schutz der elektronischen Vorrichtung vor der Einwirkung von Schmutzpartikeln, Feuchtigkeit und toxischen Gasen. Die elektronische Dichtung muß somit gleichzeitig den an eine in der Bautechnik und im Maschinenbau üblicherweise angewendeten Sperrdichtung zur Verhinderung des Stoffaustausches zwischen zwei Räumen zu stellenden Anforderungen genügen.

Bei einem in der DE 39 34 845 A1 in dem dort kritisierten Stand der Technik beschriebenen elektromagnetischen Dichtungsmittel sind in einen Stoff mit gummiartiger Elastizität leitfähige metallische Festkörperpartikel eingebunden, um neben der mechanischen gleichzeitig eine elektromagnetische Abdichtung zwischen zwei Gehäuseteilen zu bewirken. Als hervorragend leitfähige Komponente wird Silber verwendet, das jedoch zum einen teuer und zum anderen in der für die Erzielung der erforderlichen Leitfähigkeit notwendigen Menge zu einer die Wirkung als Sperrdichtung verschlechternden Elastizitätsminderung und zu einer deutlichen Erhöhung des spezifischen Gewichts der Dichtung führt. Die DE 39 34 845 A1 schlägt zur Lösung der vorstehenden Problematik eine leitfähige Dichtung vor, die aus einem nichtleitenden elastischen Dichtelement und einer auf das auf der betreffenden Dichtfläche befindliche nichtleitende Dichtelement aufgetragenen leitenden Schicht, deren Randbereiche in direktem Kontakt mit der Gehäuse-oberfläche stehen, gebildet ist. Die leitfähige Schicht besteht aus einem mit einem leitfähigen Zusatz vermischten elastischen Stoff.

Auf diese Weise wird eine leitfähige Dichtung mit geringem Metallanteil und hoher Elastizität zur Verfügung gestellt. Nachteilig ist jedoch das aufwendige Herstellungsverfahren, wonach zunächst auf die Dichtfläche eines Gehäuses eine Paste in Form eines Strangs aufgetragen wird und die Paste danach zu einem gummielastischen Dichtprofil aushärtet, auf das und die diesem benachbarten Bereiche der Dichtspaltfläche in einem weiteren Verfahrensschritt die leitfähige Schicht in Form einer verflüssigten Masse aufgespritzt wird. Neben der aufwendigen Ausbildung des Dichtstranges ist dieses Verfahren noch insofern nachteilig, als für die aufgespritzte leitfähige Schicht ein erhöhter Platzbedarf erforderlich ist.

Bei der gegenüber dem zuvor erwähnten Stand der Technik prioritätsjüngeren DE 43 19 965 C2 wird auf die abzudichtende Gehäuseoberfläche ebenfalls ein pastöses Ausgangsmaterial aufgetragen, das auch zu einem Dichtelement bestimmter Form elastisch erhärtet. Gemäß dieser Lösung ist jedoch das elastische Ausgangsmaterial in bekannter Weise mit den leitfähigen Partikeln vermischt. Daraus resultieren die bereits in der Kritik des dem Vorschlag nach der DE 39 34 845 A1 zuzuordnenden Standes der Technik erörterten Nachteile, die in den hohen Kosten für den großen Silberanteil, dem hohen Gewicht, der mit wachsendem Metallanteil verringerten Elastizität und der somit verschlechterten Dichtwirkung aufgrund ungenügenden Kontakts mit der Dichtspaltfläche bestehen.

Zur Verbesserung der Elastizitätseigenschaften des aus dem mit den leitfähigen Stoffen vermischten elastischen Material gebildeten Abschirmprofils schlägt die in der DE 43 19 965 C2 offenbarte Lösung eine aus mehreren Einzelsträngen gebildete Dichtung vor, um Profilquerschnitte in einer eine bestimmte Elastizität bewirkenden Form zu erzeugen. Das Aufbringen mehrerer Abdichtstränge ist verfahrensseitig und apparativ aufwendig und hat zudem einen erhöhten Platzbedarf, breitere Gehäuseoberfläche und höhere Materialkosten zur Folge.

Bei der Abdichtung des zwischen zwei Gehäuseteilen verbleibenden Spaltes bereitet oftmals der Ausgleich der zwischen dem Gehäuse und dem Deckel bestehenden Maßabweichungen Schwierigkeiten, so daß bei großen Toleranzen kostenintensive Dichtungen mit größerem Durchmesser und zudem erhebliche, zum Verziehen des Gehäuses führende Schließkräfte erforderlich sind.

Der Erfindung liegt daher die Aufgabe zugrunde, eine elektrisch leitende Dichtung zur Verhinderung des Stoffaustausches und zur elektromagnetischen Abschirmung von in einem leitfähigen Gehäuse untergebrachten elektronischen Bauteilen zu entwickeln, die bei geringem Platz- und Kostenaufwand über eine hohe Elastizität und Dichtwirkung verfügt und mit geringem Aufwand hergestellt werden kann.

Erfindungsgemäß wird die Aufgabe bei einer elektrisch leitfähigen Dichtung gemäß dem Oberbegriff des Patentanspruchs 1 in der Weise gelöst, daß sie durch Koextrusion zwei- oder mehrschichtig ausgeführt und mindestens aus einem innenliegenden, von leitenden Bestandteilen freien elastischen Dichtstoffstrang und einem diesen ringförmig umhüllenden äußeren Leitmittelstrang mit geringer Eigenelastizität aus mit elektrisch leitenden Bestandteilen vermischtem Dichtstoff gebildet ist.

Der Grundgedanke der Erfindung liegt mit anderen Worten in der Bildung einer leitfähigen Dichtung aus einem nichtleitenden, großvolumigen und damit hochelastischen Kern und einer vergleichsweise dünnwandigen flexiblen leitenden Umhüllung, die aus einem mit leitenden Partikeln vermischten elastischen Dichtstoff besteht, wobei beide unterschiedlichen Stoffe gleichzeitig extrudiert und in noch plastischem unausgehärtetem Zustand auf die Dichtfläche aufgetragen werden.

Damit wird eine Dichtung zur Verfügung gestellt, die aufgrund des großvolumigen und von leitenden Bestandteilen freien Kerns insgesamt hochelastisch ist und daher mit geringen Schließkräften ein sicheres Abdichten der Verbindungsstelle zwischen Gehäusedeckel und -unterteil, und zwar ohne Verziehen des Gehäuses selbst bei größeren Toleranzen, ermöglicht. Die hohe Elastizität der erfindungsgemäßen Dichtung gewährleistet auch nach längerer Belastung ausreichend hohe Rückstellkräfte und somit auch nach mehreren Öffnungs- und Schließvorgängen eine sichere Strahlungsabschirmung und Abdichtung gegen Stoffaustausch. Aufgrund dessen, daß der Leitmittelstrang als den Dichtmittelstrang allseitig umhüllende Hülse ausgebildet ist, kann bei geringem Platzbedarf in Anbetracht der hohen Elastizität eine sichere elektrische Verbindung zwischen den Abdichtflächen hergestellt werden, so daß die Wirkung des Gehäuses als Faradayscher Käfig nicht unterbrochen ist. Der vergleichsweise geringe Anteil an in der Umhüllung dennoch dicht gepackten und eine hohe Leitfähigkeit garantierenden elektrisch leitenden Partikeln wirkt sich zudem gewichts- und kostenmindernd aus.

Von wesentlichem Vorteil ist die einfache Art der Herstellung der vorgeschlagenen leitenden Dichtung, die durch Koextrusion des Dichtstoff- und des Leitmittelstranges aus einem jeweils separat pastös vorliegenden Ausgangsmaterial aus einem beweglichen Koextrusionskopf, geführt durch einen x-y-z Roboter, bzw. auf eine bewegliche Dichtfläche in einem einzigen Arbeitsgang erfolgt. Dabei kann die Gesamtstärke der Dichtung, abgesehen von der Dimensionierung des Koextrusionskopfes bzw. der Austrittsdüse, bereits durch die Verfahrgeschwindigkeit des x-y-z Roboters, mit welcher der anfangs pastöse Strang auf die Dichtfläche des Gehäuseteils aufgetragen wird, eingestellt werden. Durch Änderung des Extrusionsdruckes und Einstellung des Koextruisonkopfes kann die Stärke des Dichtstoffstranges und des Leitmittelstranges auf der Grundlage der Gehäuseausführung bestimmt werden. Dabei wird der innenliegende Dichtstoffstrang bei der Abdichtung von metallisierten, dünnwandigen Kunststoffgehäusen, die mit geringen Deckelschließkräften verzugsfrei verschlossen werden müssen, oder bei zwischen den beiden Gehäuseteilen auszugleichenden großen Toleranzen mit einem vergleichsweise großen Durchmesser ausgebildet, während beispielsweise bei stabilen Druckgußgehäusen, die auch mit großen Schließkräften miteinander verbunden werden können, bereits Dichtstoffstränge mit geringerem Durchmesser ausreichen.

Gemäß einem weiteren wichtigen Merkmal der Erfindung kann die leitende Dichtung auch mehrschichtig ausgebildet sein, indem zwischen dem Dichtmittelstrang und dem außenliegenden Leitmittelstrang noch ein Absorberstrang, der aus einem Dichtstoff und in diesen eingelagerten magnetischen Komponenten gebildet ist, vorgesehen ist. Dadurch kann die aufgrund der Reflexion abschirmende Wirkung des Leitmittelstranges durch Absorption der Störstrahlen unterstützt werden.

Schließlich ist es auch möglich, mehrere Schichten aus leitmittelfreien und mit leitenden Komponenten gefüllten Dichtstoffen im Wechsel sowie mit einer oder mehreren Absorberschichten anzuordnen.

In vorteilhafter Ausgestaltung der Erfindung wird als Dichtstoff ein Elastomer, vorzugsweise ein Silikonelastomer verwendet, das bei Raumtemperatur und bestimmter Luftfeuchtigkeit, gegebenenfalls auch unter Wärmezufuhr, in der Form des koextrudierten Stranges formstabil zu einer elastischen, an der Abdichtfläche haftenden elastischen Dichtung erhärtet.

Als Leitmittel werden Ruß- oder Metallpartikel, vortugsweise jedoch Füllstoffe aus Silber oder versilberten Metall- oder Glaspartikeln eingesetzt. Soweit ein Absorberstrang in die Dichtung integriert ist, besteht dieser aus dem betreffenden Dichtstoff und magnetischen Komponenten, wie Eisen oder Nickel, als Füllmaterial.

In den Unteransprüchen und dem Ausführungsbeispiel sind weitere zweckmäßige Ausgestaltungen bzw. Vorteile der Erfindung angegeben.

Ein Ausführungsbeispiel der Erfindung wird anhand der Zeichnung näher erläutert. Es zeigen:
Fig. 1 einen senkrechten Schnitt durch eine auf eine Dichtfläche eines elektrisch leitenden Gehäuseteils aufgetragene elektrisch leitfähige zweischichtige Dichtung;
Fig. 2 eine Schnittansicht gemäß Fig. 1, jedoch mit veränderter Schichtdicke; und
Fig. 3 eine Schnittansicht einer mehrschichtigen Dichtung mit integrierter Absorberschicht.

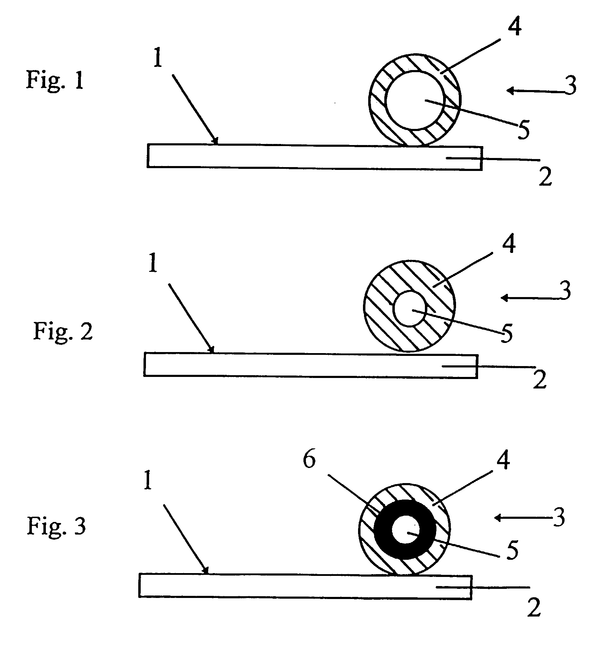

In den Figuren 1 bis 3 bezeichnet das Bezugszeichen 1 eine untere Dichtfläche eines zwischen einem Gehäuseunterteil 2 und einem Gehäusedeckel (nicht dargestellt) gebildeten Dichtspaltes. Die elektrisch leitfähige Dichtung 3 besteht aus einem außenliegenden ringförmigen Leitmittelstrang 4 und einem innenliegenden Dichtstoffstrang 5. Gemäß Fig. 1 hat der ringförmige Leitmittelstrang 4 eine im Vergleich zum Dichtstoffstrang 5 geringe Wandstärke, während dessen Wandstärke in Fig. 2 deutlich größer und der Durchmesser des innenliegenden Dichtstoffstranges 5 entsprechend geringer ist. Fig. 3 zeigt noch eine weitere Ausführungsvariante mit dreischichtigem Aufbau, d.h. mit einem zwischen dem Leitmittelstrang 4 und dem elastischen Dichtstoffstrang 5 liegenden Absorberstrang 6.

Der Dichtstoffring 5 besteht aus einem Silikonelastomer, während der Leitmittelstrang 4 aus mit Silberbestandteilen vermischtem Silikonelastomer und schließlich die Absorberschicht 6 aus Silikonelastomer und darin eingebetteten Eisenpartikeln gebildet ist. Der ringförmige Leitmittelstrang 4 ist aufgrund des vergleichsweise hohen Silberanteils in einer dünnen Silikonelastomerschicht stark leitfähig, so daß auf die leitfähige Dichtung auftreffende Störstrahlen reflektiert oder in das leitfähige Gehäuse weitergeleitet werden. Trotz der geringen Eigenelastizität ist diese Schicht dennoch flexibel und dehnbar. Die hohe Elastizität der elektrisch leitfähigen Dichtung 3 wird hingegen durch den von leitenden Einlagen freien und zudem ein großes Volumen einnehmenden Dichtstoffstrang 5 bewirkt, so daß auch bei Maßabweichungen des Dichtspaltes eine hohe Dichtwirkung zur Vermeidung des Stoffaustausches und gleichzeitig eine leitende Verbindung zwischen den Gehäuseteilen gesichert ist, da der Leitmittelstrang 4 fest an den Dichtflächen 1 des Gehäuses 2 anhaftet. Der Durchgang von Störstrahlen durch den Dichtspalt wird zusätzlich durch den Absorberstrang 6, in dem am Leitmittelstrang nicht reflektierte Strahlen absorbiert werden, verhindert.

Selbstverständlich kann die Dichtung 3 auch aus mehreren im Wechsel angeordneten Schichten gebildet sein oder auch nur aus einem außenliegenden ringförmigen Leitmittelstrang und einem innenliegenden Absorberstrang bestehen.

Das Auftragen der leitfähigen Dichtung 3 erfolgt aus einem über die Dichtfläche 1 des Gehäusteils 2 verfahrbaren Extruder, aus dem gleichzeitig der Dichtstoffstrang 5 und der Leitmittelstrang 4 durch Koextrusion in noch plastischem Zustand ausgepreßt und der frisch ausgepreßte Strang während der Fahrbewegung auf der Dichtfläche 1 abgelegt wird. Das beim Auspressen noch plastische Silikonelastomer der Leitmittelschicht 4 haftet an der Dichtfläche 1, wobei das Silikonelastomer anschließend unter Bildung eines formstabilen Dichtungsstranges bei Raumtemperatur oder Wärmezufuhr erhärtet und eine feste und bleibende Verbindung mit der Dichtfläche 1 bildet.

### Bezugszeichenliste

- 1: Dichtfläche
- 2: Gehäuseteil
- 3: leitfähige Dichtung
- 4: ringförmiger Leitmittelstrang
- 5: Dichtstoffstrang
- 6: ringförmiger Absorberstrang

## Patentansprüche

1. Elektrisch leitfähige Dichtung, bestehend aus einem in frisch extrudiertem, noch plastischem Zustand auf eine Dichtfläche aufgetragenen, mit elektrisch leitenden Bestandteilen vermischten Dichtstoff, für den Dichtspalt eines elektromagnetische Bauteile aufnehmenden leitfähigen Gehäuses zur elektromagnetischen Abschirmung und zur Verhinderung des Stoffaustausches über den Dichtspalt, dadurch gekennzeichnet, daß sie durch Koextrusion zwei- oder mehrschichtig ausgeführt und mindestens aus einem innenliegenden, von leitenden Bestandteilen freien, elastischen Dichtstoffstrang (5) und einem diesen ringförmig umhüllenden außenliegenden Leitmittelstrang (4) mit geringer Eigenelastizität und Wandstärke aus mit elektrisch leitenden Bestandteilen vermischtem Dichtstoff gebildet ist.

2. Elektrisch leitfähige Dichtung nach Anspruch 1, dadurch gekennzeichnet, daß in ihrem Innern weitere ringförmige Dichtstoff- und Leitmittelringe angeordnet sind.

3. Elektrisch leitfähige Dichtung nach Anspruch 1 oder 2, gekennzeichnet durch mindestens einen innenliegenden Absorberstrang (6) aus mit magnetischen Bestandteilen vermischtem elastischem Dichtstoff.

4. Elektrisch leitfähige Dichtung nach Anspruch 3, dadurch gekennzeichnet, daß der Absorberstrang (6) ringförmig ausgebildet ist und zwischen dem Dichtstoffstrang (5) und dem Leitmittelstrang (4) liegt.

5. Elektrisch leitfähige Dichtung nach Anspruch 3, dadurch gekennzeichnet, daß der Absorberstrang als zentral angeordneter Vollstrang ausgebildet ist, der von einem Leitmittelstrang oder einem Dichtstoffstrang und einem Leitmittelstrang umgeben ist.

6. Elektrisch leitfähige Dichtung nach einem der Ansprüche 1 bis 5, dadurch gekennzeichnet, daß die Stärke des Dichtstoff- und Leitmittelstranges sowie des Absorberstranges veränderlich ist.

7. Elektrisch leitfähige Dichtung nach Anspruch 1, dadurch gekennzeichnet, daß der in plastischem Zustand aufgetragene Dichtstoff ein bei Raumtemperatur und Luftfeuchtigkeit oder unter Wärmezufuhr zu einem gummielastischen Formkörper aushärtendes Elastomer ist.

8. Elektrisch leitende Dichtung nach Anspruch 7, dadurch gekennzeichnet, daß der Dichtstoff ein Silikonelastomer ist.

9. Elektrisch leitende Dichtung nach Anspruch 1, dadurch gekennzeichnet, daß die leitenden Bestandteile des Leitmittelstranges (4) aus Ruß- oder Metallpartikeln bestehen.

10. Elektrisch leitende Dichtung nach Anspruch 9, dadurch gekennzeichnet, daß die leitenden metallischen Bestandteile aus Silber oder silberummantelten Metall- oder Glaspartikeln bestehen.

11. Elektrisch leitende Dichtung nach Anspruch 3, dadurch gekennzeichnet, daß die magnetischen Bestandteile des Absorberstrangs aus Nickel und/oder Eisen bestehen.

12. Verfahren zur Herstellung einer elektrisch leitfähigen Dichtung nach einem der vorhergehenden Ansprüche, gekennzeichnet durch Koextrusion des Dichtstoff- und Leitmittelstranges und gegebenenfalls des Absorberstranges jeweils aus einem noch pastösen Ausgangsmaterial unmittelbar auf eine Dichtfläche (1).

13. Verfahren nach Anspruch 12, dadurch gekennzeichnet, daß die Koextrusion und das Auftragen während einer Relativbewegung zwischen einem Koextrusionswerkzeug und einer Dichtfläche erfolgt, wobei der Dichtstoff kontinuierlich auf die Dichtfläche aufgebracht wird und anschließend formstabil aushärtet.

14. Verfahren nach Anspruch 13, dadurch gekennzeichnet, daß das Koextrusionswerkzeug über die Dichtfläche eines feststehenden Gehäuseteils (2) bewegt wird.

15. Verfahren nach Anspruch 13, dadurch gekennzeichnet, daß das Gehäuseteil (2) mit seiner Dichtfläche (1) unterhalb des feststehenden Koextrusionswerkzeugs bewegt wird.

16. Verfahren nach einem der Ansprüche 12 bis 15, dadurch gekennzeichnet, daß die Bewegungsgeschwindigkeit des Koextrusionswerkzeugs oder des Gehäuseteils zur Beeinflussung der Stärke der Dichtung veränderlich ist.

17. Verfahren nach einem der Ansprüche 12 bis 16, dadurch gekennzeichnet, daß der jewelige Extrusionsdruck zur Ausbildung des Dichtstoffstranges (5), des Leitmittelstranges (4) und des Absorberstranges (6) in einer jeweils gewünschten veränderlichen Stärke variabel einstellbar ist.
